# EUROPEAN PATENT APPLICATION

(11) **EP 4 727 275 A1**
(43) Date of publication of application: **15.04.2026**
(21) Application number: 24838350.7
(22) Date of filing: 21.03.2024
(51) Int. Cl.: H05K 7/14, H05K 1/18

(54) **FLEXIBLE CIRCUIT BOARD AND ELECTRONIC DEVICE**

(30) Priority: 11.07.2023 CN 202310851357
(71) Applicant: Honor Device Co., Ltd., Shenzhen, Guangdong 518040 (CN)
(72) Inventor: XUE, Kangle, Shenzhen, Guangdong 518040 (CN); ZHOU, Pinrui, Shenzhen, Guangdong 518040 (CN); WANG, Wenhao, Shenzhen, Guangdong 518040 (CN); YANG, Lijun, Shenzhen, Guangdong 518040 (CN)
(74) Representative: Gill Jennings & Every LLP
(86) International application number: PCT/CN2024/083001
(87) International publication number: WO 2025/011090

(57) **Abstract**

This application provides a flexible printed circuit and an electronic device. The flexible printed circuit comprises at least one moving section arranged along its length direction. By providing a dividing groove in at least one moving section, the dividing groove divides the moving section into a first portion and a second portion. The dividing groove may absorb a deformation generated when the flexible printed circuit bends, and the first portion and the second portion are completely divided and do not affect each other, reducing the deformation of the first portion and the second portion, reducing the overall arching degree of the flexible printed circuit, and reducing the pressure exerted by the flexible printed circuit on adjacent components. As a result, issues such as abnormal pressing noise and film printing of the electronic device can be improved.

## Description

This application claims priority to Chinese Patent Application No. 202310851357.X, filed with the China National Intellectual Property Administration on July 11, 2023 and entitled "FLEXIBLE PRINTED CIRCUIT AND ELECTRONIC DEVICE", which is incorporated herein by reference in its entirety.

### TECHNICAL FIELD

This application relates to the field of electronic devices, and in particular, to a flexible printed circuit and an electronic device.

### BACKGROUND

A foldable electronic device is typically provided therein with a through-shaft FPC (Flexible Printed Circuit, flexible printed circuit), where the through-shaft FPC is configured to pass through a rotating shaft and connect components located in middle frames on both sides of the rotating shaft to enable new signal transmission between the components in the middle frames on two sides.

Due to tolerances of the components of the electronic device during production and installation, it is usually necessary to reserve a certain redundant length for the through-shaft FPC to compensate for the tolerances of these components and to meet a bending requirement of the through-shaft FPC. However, under a condition where the components are well installed, the redundant length of the through-shaft FPC cannot be effectively utilized. On the contrary, there are phenomena such as accumulating, bending, and arching in the through-shaft FPC, and in severe cases, the through-shaft FPC may adhere closely to and squeeze adjacent components, causing issues such as abnormal pressing noise.

### SUMMARY

This application provides a flexible printed circuit and an electronic device, where the flexible printed circuit may address issues such as redundant warping and abnormal pressing noise caused by squeezing the components.

On one hand, this application provides a flexible printed circuit configured to be installed in an electronic device. The flexible printed circuit comprises at least one moving section arranged along a length direction of the flexible printed circuit, and the moving section is movable in the electronic device; wherein the at least one moving section is provided with a dividing groove, and the dividing groove divides the moving section into a first portion and a second portion along a width direction of the flexible printed circuit.

The flexible printed circuit provided by this application comprises at least one moving section arranged along its length direction. By providing the dividing groove on at least one moving section, the moving section is divided into the first portion and the second portion along the width direction of the flexible printed circuit by utilizing the dividing groove. The dividing groove may absorb deformations generated when the flexible printed circuit is bent, and the first portion and the second portion are completely divided and do not affect each other, which may reduce the deformations of the first portion and the second portion, reduce an overall arching degree of the flexible printed circuit, and reduce the pressure exerted by the flexible printed circuit on the adjacent components. As a result, issues such as the abnormal pressing noise and film printing of the electronic device may be improved.

In a possible implementation, the first portion is an integrated portion, and at least a portion of the second portion is a multilayer section, where the multilayer section comprises at least two structural layers arranged along a thickness direction of the flexible printed circuit, and the structural layers are separated from each other.

By designing the first portion as the integrated portion and designing at least a portion of the second portion as a multilayer region, the multilayer region comprises at least two structural layers that are sequentially stacked and separated from each other. The dividing groove completely divides the first portion and the second portion, where the first portion has a relatively higher overall hardness and better resistance to deformation, which may reduce the arching degree, and the second portion has a relatively low hardness and high flexibility due to its multilayer region. Due to the presence of an air layer between the structural layer of the multilayer region, the pressure exerted on the adjacent components is relatively small, and an overall deformation degree of the flexible printed circuit may be reduced, and the pressure of the flexible printed circuit on the adjacent components may be lowered.

In a possible implementation, at least a portion of radio frequency signal lines in the flexible printed circuit are distributed to the first portion.

By arranging a portion or even all of the radio frequency signal lines in the first portion, where the first portion is an integrated portion, the performance of the radio frequency signal lines may be ensured, avoiding radio frequency signal loss, and contributing to improve a communication efficiency and a call quality of the electronic device.

In a possible implementation, the dividing groove comprises a main groove section, where an extending direction of the main groove section forms an angle with the width direction of the flexible printed circuit, and the main groove section extends to both ends of the moving section.

By providing the main groove section forming the angle with the width direction of the flexible printed circuit, the main groove section extends to both ends of the moving section, and the main groove section divides the moving section into the first portion and the second portion.

In a possible implementation, two sides of the flexible printed circuit in the width direction are configured as a first side and a second side, respectively, wherein the main groove section is located near the first side, and the first portion is located between the first side and the main groove section.

By locating the main groove section of the dividing groove near the first side of the flexible printed circuit, the first portion is located on a side of the flexible printed circuit where the first side is located, so that the first portion occupies a relatively small width, avoiding the hardness of the first portion from becoming excessively high, ensuring the overall bending performance of the moving section, and reducing a jacking force exerted by the first portion on the adjacent components.

In a possible implementation, at least a portion of the main groove section extends along the length direction of the flexible printed circuit.

By extending the main groove section along the length direction of the flexible printed circuit, the space occupied by the main groove section in the width direction of the flexible printed circuit is very small, resulting in little interference with routing paths of the wiring in the flexible printed circuit. This may allow the wiring in the flexible printed circuit to remain uniform, reduce signal interference, and improve the signal transmission performance of the flexible printed circuit.

In a possible implementation, the dividing groove further comprises at least one branch groove section, and the branch groove section intersects with and communicates with the main groove section.

By providing the branch groove section intersecting with and communicating with the main groove section, an area of the dividing groove is increased, and since the branch groove section and the main groove section have an intersection portion, the ability of the dividing groove to absorb the bending deformation of the moving section is enhanced, enabling better release of stress in the moving section, reducing the arching degree of the moving section, and alleviating the jacking force exerted by the moving section on the adjacent components.

In a possible implementation, the branch groove section is located in the second portion, wherein an end of the branch groove section communicates with the main groove section, and another end of the branch groove section extends in a direction away from the main groove section.

By providing the branch groove section in the second portion, one end of the branch groove section communicates with the main groove section, and the branch groove section does not occupy the space of the first portion, thereby preventing the first portion from becoming locally too narrow and ensuring the reliability of the first portion.

In a possible implementation, the branch groove section is connected to the middle portion of the main groove section.

In a possible implementation, the branch groove section is connected to an end of the main groove section.

In a possible implementation, the main groove section is an arc-shaped section, and the branch groove section extends along a tangential direction of the main groove section.

In a possible implementation, the at least one moving section provided with the dividing groove is a bending section, and the bending section bends toward a side where the first portion is located.

By providing the dividing groove in the moving section formed as the bending section, the dividing groove divides and forms the side of the bending section where a corner portion is located into a first portion, and the dividing groove may absorb the bending deformation at the corner portion. By configuring the first portion as the integrated portion, that is, configuring the corner portion as the integrated portion and maintaining a certain hardness at the corner portion, the arching degree at the corner portion is reduced.

In a possible implementation, the corner portion of the bending section is provided with a crack arrest groove, and an extending shape of the main groove section matches a shape of the crack arrest groove.

In a possible implementation, the flexible printed circuit further comprises at least two fixing portions, wherein each of the fixing portions is arranged at intervals along the length direction of the flexible printed circuit, the fixing portions are configured to be fixedly connected to the components of the electronic device, and the moving section is located between adjacent fixing portions.

By arranging fixing portions at intervals along the length direction of the flexible printed circuit, the fixing portions are configured to fix corresponding sections of the flexible printed circuit in the electronic device, so as to fix the overall position of the flexible printed circuit. At least both ends of the flexible printed circuit are fixing portions, and the fixing portions at both ends of the flexible printed circuit are configured to connect with corresponding components.

In a possible implementation, the at least two fixing portions comprise two end fixing portions and at least one middle fixing portion, wherein the two end fixing portions are located at both ends of the flexible printed circuit, respectively, the end fixing portions are configured to connect with the components in the electronic device, and the middle fixing portion is located between the two end fixing portions;
wherein the moving section between at least one of the end fixing portions and the adjacent middle fixing portion is provided with the dividing groove.

The moving section between the end fixing portion and the middle fixing portion adjacent thereto is located near the end of the flexible printed circuit. The moving section near the end of the flexible printed circuit has a limited moving space, and a distance between the moving section and the adjacent components of this region is smaller. By providing the dividing groove in the moving section of this region, the arching degree of the moving section of this region is weakened, the interference between the moving section and the adjacent components of this region is improved, and the issues such as abnormal pressing noise and film printing of the electronic device are improved.

In a possible implementation, in the moving section provided with the dividing groove and located between the end fixing portion and the middle fixing portion, two side regions of the second portion are multilayer sections, and a middle region thereof is an integrated section.

In a possible implementation, the moving section between adjacent middle fixing portions is the multilayer section.

The moving section between the adjacent middle fixing portions typically has a relatively large moving space, which may meet the deformation space requirement of the moving section. Therefore, the entire moving section may be designed as the multilayer section, which may make the moving section more flexible, so as to reduce the jacking force exerted by the moving section on the adjacent components.

In a possible implementation, along the extending direction of the main groove section, the main groove section comprises a first section, a middle section, and a second section connected in sequence, and a maximum width of the first section and a maximum width of the second section are both smaller than a minimum width of the middle section.

By making the maximum width of the first section and the maximum width of the second section of the main groove section both smaller than the minimum width of the middle section, the main groove section is designed as a structure that is wide in the middle and narrow at both ends. This increases the width of the middle region of the main groove section, enhances the ability of the main groove section to absorb the bending deformation of the moving section, enables better release of stress in the moving section, and reduces the arching degree of the moving section.

In a possible implementation, a width of the main groove section gradually decreases from a center of the main groove section toward an edge of the main groove section.

Based on an architecture in which the main groove section is wide in the middle and narrow at both ends, the width of the main groove section is gradually varied, thereby avoiding step differences at a connecting portion between the first section and the middle section and at a connecting portion between the second section and the middle section, and preventing reliability issues such as local tearing and breakage caused by the step differences.

In a possible implementation, the dividing groove penetrates through two side surfaces of the flexible printed circuit in the thickness direction.

By making the dividing groove penetrate through two side surfaces of the flexible printed circuit in the thickness direction, the dividing groove completely divides the first portion and the second portion, where the bending and deformation of the first portion and the second portion each are not affected at all. This may completely isolate the impact of the relatively rigid first portion on the multilayer section of the second portion, making the multilayer section of the second portion fully exhibit its flexible characteristics.

In a possible implementation, in the thickness direction of the flexible printed circuit, the moving section bends toward the first direction;
along the first direction, the multilayer section comprises a bottom layer and at least one stacked layer stacked on the bottom layer, wherein the dividing groove penetrates through each stacked layer, and the bottom layer is connected with the first portion.

By connecting the bottom layer of the multilayer section together with the first portion, the dividing groove penetrates only through each stacked layer of the multilayer section. In each structural layer of the multilayer section, only the moving of its bottom layer is affected by the first portion, and the first portion may also reduce the arching degree of the bottom layer together. Each stacked layer of the multilayer section may still move freely, which may ensure that the multilayer section fully exhibits its flexible characteristics and reduce the jacking force exerted by the multilayer section on the adjacent components.

On the other hand, this application provides an electronic device, comprising a housing assembly and the flexible printed circuit as described above, wherein the flexible printed circuit is located in the housing assembly, and the flexible printed circuit is connected with at least two components in the housing assembly.

The electronic device provided in this application comprises the housing assembly and the flexible printed circuit installed in the housing assembly, and the flexible printed circuit comprises at least one moving section arranged along its length direction. By providing the dividing groove on at least one moving section, the moving section is divided into the first portion and the second portion along the width direction of the flexible printed circuit by utilizing the dividing groove. The dividing groove may absorb the deformation generated when the flexible printed circuit is bent, and the first portion and the second portion are completely divided and do not affect each other. This may reduce the deformations of the first portion and the second portion, reduce the overall arching degree of the flexible printed circuit, and reduce the pressure exerted by the flexible printed circuit on the adjacent components. As a result, the issues such as abnormal pressing noise and film printing of the electronic device can be improved.

In a possible implementation, the housing assembly comprises a first middle frame, a second middle frame, and a rotating shaft, and the first middle frame and the second middle frame are movably connected to two sides of the rotating shaft, respectively;
wherein a first end of the flexible printed circuit is connected with components installed to the first middle frame, and a second end of the flexible printed circuit passes through the rotating shaft and is connected with components installed to the second middle frame.

In a possible implementation, the electronic device further comprises a first display screen, wherein the first display screen is attached to a first side of the first middle frame and of the second middle frame.

In a possible implementation, the electronic device further comprises a second display screen, wherein the second display screen is attached to a second side of the second middle frame, and the second side is opposite to the first side; and
wherein the moving section near the second end of the flexible printed circuit is provided with the dividing groove.

By providing the dividing groove in the moving section near the second end of the flexible printed circuit, the arching degree of the moving section near the second end of the flexible printed circuit is weakened. This improves interference phenomena between the moving section and the second display screen, reduces the jacking force exerted by the moving section on the second display screen, and even prevents the moving section from contacting the second display screen, thereby improving the issues such as abnormal pressing noise and film printing of the second display screen.

### BRIEF DESCRIPTION OF DRAWINGS

FIG. 1 is a schematic structural diagram of an electronic device according to an embodiment of this application;
FIG. 2 is an exploded structural diagram of the electronic device shown in FIG. 1;
FIG. 3 is a schematic structural diagram of another electronic device according to an embodiment of this application;
FIG. 4 is a schematic structural diagram of the electronic device in FIG. 3 in a semi-unfolded state;
FIG. 5 is a schematic structural diagram of the electronic device in FIG. 3 in a folded state;
FIG. 6 is an exploded structural diagram of the electronic device in FIG. 3;
FIG. 7 is a schematic diagram of an electrical connection structure of a foldable electronic device according to an embodiment of this application;
FIG. 8 is a diagram of a partial structure of a foldable electronic device according to an embodiment of this application.
FIG. 9 is a schematic diagram of an installation condition of a flexible printed circuit;
FIG. 10 is a schematic structural diagram of a flexible printed circuit in a related technology;
FIG. 11 is a schematic structural diagram of a flexible printed circuit according to an embodiment of this application;
FIG. 12 is a schematic structural diagram of the flexible printed circuit in FIG. 11 in an unfolded state;
FIG. 13 is a schematic cross-sectional diagram along A-A in FIG. 12;
FIG. 14 is a partial enlarged diagram of another flexible printed circuit at a position of a dividing groove according to an embodiment of this application;
FIG. 15 is a schematic structural diagram of a third flexible printed circuit in an unfolded state according to an embodiment of this application;
FIG. 16 is a schematic structural diagram of a fourth flexible printed circuit in an unfolded state according to an embodiment of this application;
FIG. 17 is a schematic structural diagram of a fifth flexible printed circuit in an unfolded state according to an embodiment of this application.

### DESCRIPTION OF EMBODIMENTS

Terms used in implementations of this application are merely intended to explain specific embodiments of this application rather than being intended to limit this application.

An embodiment of this application provides an electronic device, and the electronic device may be an electronic product of a consumption type. For example, the electronic device includes but is not limited to a mobile phone, a portable android device (portable android device, PAD), a notebook computer (NoteBook Computer, referred to as NoteBook for short), an ultra-mobile personal computer (ultra-mobile personal computer, UMPC), a walkie-talkie, a netbook, a POS (Point of sales) machine, a personal digital assistant (personal digital assistant, PDA), a wearable device, a virtual reality (virtual reality, VR) device, or an augmented reality (augmented reality, AR) device.

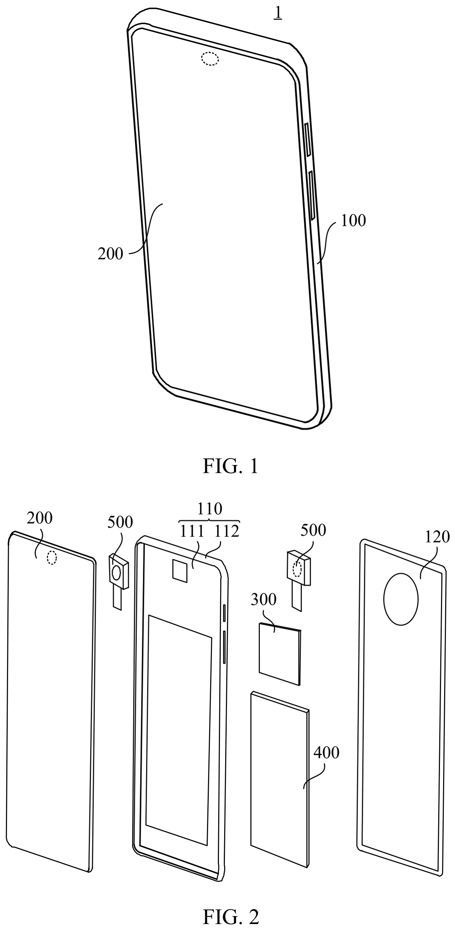

FIG. 1 is a schematic structural diagram of an electronic device according to an embodiment of this application. As shown in FIG. 1, an example in which the electronic device 1 is a straight plate electronic device is used, for example, the electronic device 1 is a straight plate mobile phone, and the electronic device 1 may include a housing assembly 100 and a display screen 200. A side surface of the display screen 200 is configured to display image information, where the side surface of the display screen 200 is generally defined as a front surface of the display screen, and another side surface opposite to the front surface is defined as a back surface of the display screen. The housing assembly 100 is arranged around a periphery and the back surface of the display screen 200 and is configured to support and fix the display screen 200 and provide protection. The front surface of the display screen 200 is exposed outside the housing assembly 100, for a user to watch content displayed by the display screen 200 or perform an input operation on the electronic device 1.

Using the straight plate electronic device shown in the figure as an example, the display screen 200 of the electronic device 1 may be a rigid screen, and the display screen 200 may be an LCD (Liquid Crystal Display, liquid crystal display) display screen or an OLED (Organic Light-Emitting Diode, organic light-emitting diode) display screen.

FIG. 2 is an exploded structural diagram of the electronic device shown in FIG. 1. As shown in FIG. 2, the straight plate electronic device is used as an example, the housing assembly 100 of the electronic device 1 may include a middle frame 110 and a rear cover 120, where the middle frame 110 is connected between the display screen 200 and the rear cover 120, the display screen 200 is supported on a side surface of the middle frame 110, and the rear cover 120 is connected to another side surface of the middle frame 110. The display screen 200 is generally attached to the middle frame 110 as a whole to ensure the strength and reliability of the display screen 200 and meet a use requirement of the display screen 200. The rear cover 120 is generally connected to the middle frame 110 in a lapping manner, the middle frame 110 and the rear cover 120 jointly enclose an accommodating cavity, and the accommodating cavity is configured to install components such as a circuit board 300, a battery 400, a camera 500, or a microphone (not shown in figures).

The middle frame 110 may include a middle plate portion 111 and a side frame portion 112, where the middle plate portion 111 is located between the display screen 200 and the rear cover 120 and is generally arranged parallel to the display screen 200 and the rear cover 120, the side frame portion 112 is arranged around a periphery of the middle plate portion 111, and the side frame portion 112 may extend, for example, toward two sides of the middle plate portion 111 in a direction perpendicular to a plate surface of the middle plate portion 111. For example, the side frame portion 112 and the middle plate portion 111 may be an integrally formed structure.

The display screen 200 is generally attached to the middle plate portion 111 of the middle frame 110 as a whole. For example, the display screen 200 is adhered to the middle plate portion 111 as a whole, and a stable and firm support to the display screen 200 may be ensured by depending on a support of the middle plate portion 111 to the display screen 200, so that the display screen 200 has sufficient strength, thereby meeting a use requirement of the display screen 200 being frequently pressed. The side frame portion 112 is arranged around the periphery of the display screen 200 to protect a side edge of the display screen 200, to assist the display screen 200 in resisting risk scenarios such as collision and falling off, and to protect the display screen 200 from being damaged.

An edge of the rear cover 120 is connected to the side frame portion 112 of the middle frame 110. For example, the edge of the rear cover 120 is adhered to the side frame portion 112. A gap exists between the middle plate portion 111 of the middle frame 110 and the rear cover 120, and the gap forms the accommodating cavity described above, so that the components are attached in the accommodating cavity between the middle plate portion 111 of the middle frame 110 and the rear cover 120.

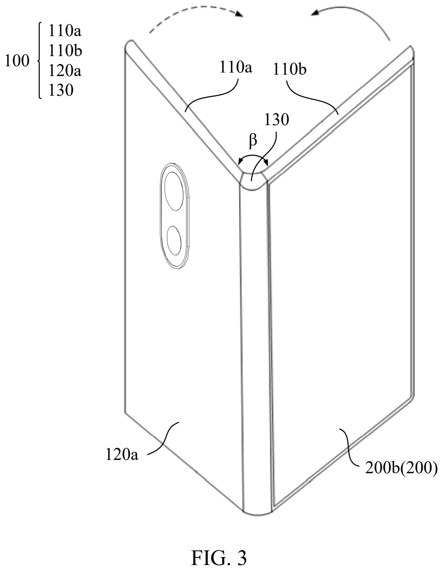

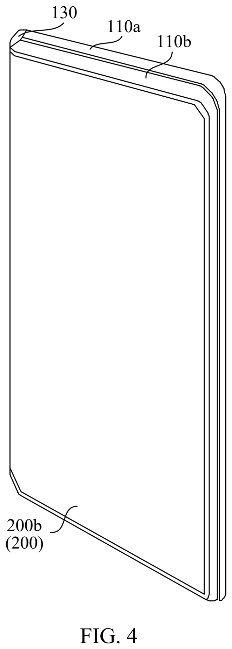

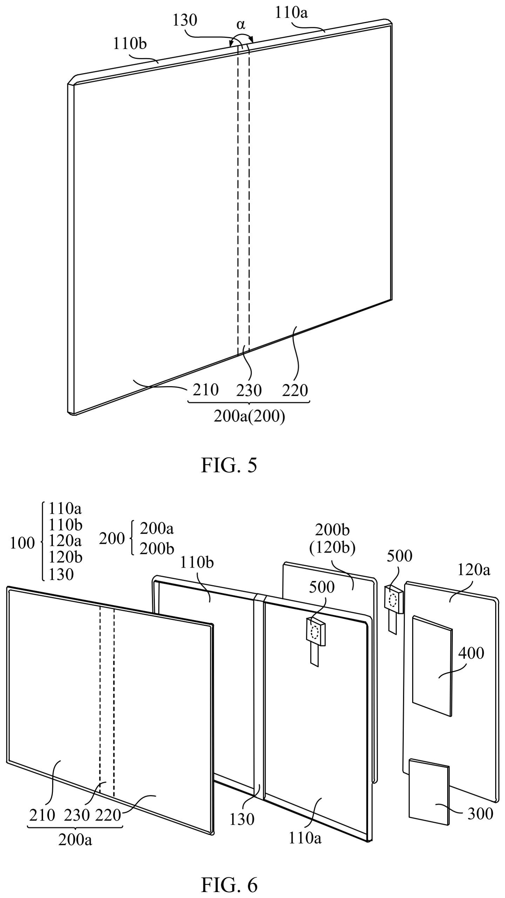

FIG. 3 is a schematic structural diagram of another electronic device according to an embodiment of this application; FIG. 4 is a schematic structural diagram of the electronic device shown in FIG. 3 in an unfolded state; FIG. 5 is a schematic structural diagram of the electronic device in FIG. 3 in a folded state.

Referring to FIG. 3 to FIG. 5, an example in which the electronic device 1 is a foldable electronic device is used, for example, the electronic device 1 is a foldable mobile phone, the electronic device 1 may include at least two portions capable of rotating relative to each other, and the electronic device 1 may include different use states in different use scenarios. An example in which the foldable electronic device is an electronic device that may be folded once is used in this embodiment, the electronic device 1 includes two portions capable of rotating relative to each other, and the use state of the electronic device 1 is changed by relative rotation of the two portions.

The two portions of the electronic device 1 may rotate relative to each other in a direction indicated by the arrow in FIG. 3. When the two portions rotate to overlap each other, electronic device 1 assumes the folded state shown in FIG. 4. In this case, electronic device 1 has a smaller volume, making it more portable. The two portions of electronic device 1 may also rotate relative to each other in a direction opposite to the arrow in FIG. 3. When the two portions rotate to lie coplanar, electronic device 1 is in the unfolded state shown in FIG. 5. An unfolded angle α of electronic device 1 is, for example, 180°. In this case, electronic device 1 may achieve a large-screen display. In certain scenarios, electronic device 1 may also maintain a semi-unfolded state (as shown in Figure 3). In this case, electronic device 1 hovers at an angle between the unfolded state and folded state. For example, the hover angle β of electronic device 1 may be 120°, 130°, 140°, or 150°, among others.

It should be noted that, each angle described in this embodiment is allowed to have a slight deviation. For example, that the unfolding angle α of the electronic device 1 is 180 degrees means that the unfolding angle α may be 180 degrees, or may be approximately 180 degrees, for example, 170 degrees, 175 degrees, 185 degrees, or 190 degrees. An angle described by using an example in the following may be understood in the same way.

Furthermore, in addition to being the electronic device 1 that may be folded once, the electronic device 1 may also be an electronic device that may be folded twice or more. In this case, the electronic device 1 may include a plurality of portions connected in a sequential rotary manner. Two adjacent portions may be folded relatively close to each other until in the folded state, and the two adjacent portions may be unfolded relatively far away from each other until in the unfolded state.

FIG. 6 is an exploded structural view of the electronic device in FIG. 3. Referring to FIG. 6, for the foldable electronic device, the electronic device 1 may also include a display screen 200 and a housing assembly 100, where a front surface of the display screen 200 is configured to display image information, and the housing assembly 100 is arranged around the periphery and the back surface of the display screen 200 and is configured to support and fix the display screen 200 and provide protection. Details are not described herein again.

The display screen 200 of the foldable electronic device may include a first display screen 200a capable of folding, where the first display screen 200a may include a first region 210, a second region 220, and a bendable region 230, and the bendable region 230 is located between the first region 210 and the second region 220. During use of the electronic device 1, the first region 210 and the second region 220 always remain in a plane state, and the bendable region 230 may be bent, to change an angle between the first region 210 and the second region 220, so that the first display screen 200a is folded or unfolded as the housing assembly 100 moves, thereby achieving switching of the electronic device 1 between the folded state and the unfolded state.

For example, in the first display screen 200a, at least the bendable region 230 is made of a flexible material, so that the bendable region 230 is bendable. The first region 210 and the second region 220 may be made of a flexible material or may be made of a rigid material, or may be partially made of a rigid material and partially made of a flexible material. This is not limited in this embodiment.

The first display screen 200a includes but is not limited to an organic light-emitting diode (organic light-emitting diode, OLED) display screen, an active-matrix organic light-emitting diode (active-matrix organic light-emitting diode, AMOLED) display screen, a mini light-emitting diode (mini organic light-emitting diode) display screen, a micro light-emitting diode (micro organic light-emitting diode) display screen, a micro organic light-emitting diode (micro organic light-emitting diode) display screen, or a quantum dot light-emitting diode (quantum dot light-emitting diode, QLED) display screen.

As shown in FIG. 4 and FIG. 6, when the first display screen 200a is in the folded state, the first region 210 and the second region 220 overlap with each other, and the bendable region 230 is in a bending state, where a bending angle of the bendable region 230 is, for example, 180 degrees. In this case, the electronic device 1 is small in size and is easy to carry and accommodate. As shown in FIG. 5 and FIG. 6, when the first display screen 200a is in the unfolded state, the first region 210 and the second region 220 are in an unfolded state of being away from each other, and the bendable region 230 is in a flattened state without bending, where the first region 210, the second region 220 and the bendable region 230 have a same orientation and are in a coplanar state. In this case, the angle between the first region 210 and the second region 220 is 180 degrees, and the first display screen 200a can implement a large-screen display, which can bring better use experience to a user.

It should be noted that, an example in which the foldable electronic device is an inner foldable architecture is used in the figures, and when the electronic device 1 is in the folded state, the first region 210 and the second region 220 of the first display screen 200a are attached to each other, and the housing assembly 100 is arranged around the outside the first display screen 200a, so that the first display screen 200a may be prevented from being scratched by a hard object. Referring to FIG. 4, if the inner foldable electronic device needs to implement a display function in the folded state, a second display screen 200b may be added to the back surface of the housing assembly 100, so that the electronic device 1 implements the display function in the folded state by depending on the second display screen 200b.

In other words, the display screen 200 of the inner foldable electronic device may include a first display screen 200a and a second display screen 200b, where the first display screen 200a may be a foldable screen installed on the front surface of the housing assembly 100, the first display screen 200a may be switched between the unfolded state and the folded state, and the second display screen 200b may be a single screen installed on the back surface of the housing assembly 100, the second display screen 200b may implement display when the electronic device 1 is in the folded state.

In other examples, the foldable electronic device may be also an outer foldable architecture, and when the electronic device 1 is in the folded state, the first region 210 and the second region 220 of the first display screen 200a are opposite to each other, the housing assembly 100 is located between the first region 210 and the second region 220, and the first display screen 200a is arranged around the outside of the housing assembly 100, so that the first display screen 200a is exposed outside and visible to the user, and the display function may be implemented by using the first display screen 200a. Therefore, there is no need to additionally add a second display screen 200b to the back surface of the housing assembly 100. In other words, the outer foldable electronic device may only include the first display screen 200a installed on the front surface of the housing assembly 100.

In addition, as shown in FIG. 3 and FIG. 6, in some implementations, especially when the foldable electronic device is the inner foldable electronic device, the electronic device 1 may hover at an angle between the unfolded state and the folded state, that is the electronic device 1 is in the semi-unfolded state, by depending on a damping force provided by the housing assembly 100. In this case, the bendable region 230 of the first display screen 200a is also in a bending state, and the first region 210 and the second region 220 of the first display screen 200a is tilted relative to each other. An example in which the hovering angle of the electronic device 1 is 120°, 130°, 140° or 150° is used, the angle between the first region 210 and the second region 220 may be 120°, 130°, 140° or 150°, correspondingly.

For the foldable electronic device, in addition to supporting and fixing the first display screen 200a, the housing assembly 100 further needs to drive the first display screen 200a to switch between the folded state and the unfolded state. Based on this, referring to FIG. 6, the housing assembly 100 of the foldable electronic device may include a first middle frame 110a, a second middle frame 110b, and a rotating shaft 130, where the rotating shaft 130 is connected between the first middle frame 110a and the second middle frame 110b, and the first middle frame 110a and the second middle frame 110b are rotatably connected through the rotating shaft 130 to implement relative rotation between the first middle frame 110a and the second middle frame 110b.

The first middle frame 110a supports and fixes the first region 210 of the first display screen 200a, and the second middle frame 110b supports and fixes the second region 220 of the first display screen 200a. In other words, the first region 210 of the first display screen 200a is attached to the first middle frame 110a, the second region 220 of the first display screen 200a is attached to the second middle frame 110b, and the bendable region 230 of the first display screen 200a is arranged corresponding to the rotating shaft 130. When the rotating shaft 1301 drives the first middle frame 110a and the second middle frame 110b to rotate relative to each other, orientations of the first region 210 and the second region 220 of the first display screen 200a change accordingly, and the bendable region 230 of the first display screen 200a is bent or flattened along with orientation changes of the first region 210 and the second region 220.

Specifically, the first middle frame 110a and the second middle frame 110b may rotate in a direction close to each other until they are stacked relative to each other. In this case, the housing assembly 100 is in the folded state, and the first display screen 200a is in the folded state as the housing assembly 100 folds, as shown in FIG. 4. The first middle frame 110a and the second middle frame 110b may also rotate in a direction away from each other until they lie coplanar. In this case, the housing assembly 100 is in the unfolded state, and the first display screen 200a is in the unfolded state as the housing assembly 100 unfolds, as shown in FIG. 5. The first middle frame 110a and the second middle frame 110b may also rotate relative to each other until they remain between the folded state and the unfolded state. In this case, the housing assembly 100 is in the semi-unfolded state (hovering state), where the angle between the first middle frame 110a and the second middle frame 110b is, for example, 120°, 130°, 140°, or 150°, and the first display screen 200a is in the semi-unfolded state along with the housing assembly 100.

Continuing to refer to FIG. 6, in this embodiment, the two opposing side surfaces of the first middle frame 110a and the second middle frame 110b are defined as their first side and second side, respectively. The first display screen 200a may be attached as a whole to the first sides of the first middle frame 110a and the second middle frame 110b. For the inward-folding electronic device with an additional second display screen 200b, an example in which the second display screen 200b is attached to a side where the second middle frame 110b is located, the second display screen 200b may be installed on the second side of the second middle frame 110b. The housing assembly 100 further includes a first rear cover 120a, and the first rear cover 120a is connected to the second side of the first middle frame 110a. For the outward-folding electronic device or inward-folding electronic device without the additional second display screen 200b, the electronic device 1 may further include the first rear cover 120a and a second rear cover 120b, where the first rear cover 120a is connected to the second side of the first middle frame 110a, and the second rear cover 120b is connected to the second side of the second middle frame 110b.

The first middle frame 110a and the first rear cover 120a together enclose a first accommodating cavity, and the second middle frame 110b and the second display screen 200b (second rear cover 120b) enclose a second accommodating cavity, where internal components of the electronic device 1 may be installed in the first accommodating cavity and the second accommodating cavity, respectively. For example, the circuit board 300 may be installed in both the first accommodating cavity and the second accommodating cavity, where at least one of the first accommodating cavity and the second accommodating cavity may be installed with other components such as the battery 400 and the camera 500, and these components may be installed on the first middle frame 110a and the second middle frame 110b.

For example, in the circuit boards 300 installed in the two accommodating cavities, one circuit board 300 installed in the first accommodating cavity (second accommodating cavity) may be a main board 310 of the electronic device 1, and the main board 310 may be provided with components such as a System-on-a-chip (System-on-a-chip, SOC) and a memory. One circuit board 300 installed in the second accommodating cavity (first accommodating cavity) may be a secondary board 320, and the secondary board 320 is provided with components that cannot be integrated onto the main board 310. For example, the secondary board 320 is provided with components such as a radio frequency device, a power management chip. At least one of the first accommodating cavity and the second accommodating cavity may further be provided with other circuit boards 300, and the other circuit boards 300 may be configured to be provided with components such as a connector, a microphone, and a speaker.

Regarding an electrical connection between the components in the electronic device 1, since certain tolerances are unavoidable during the manufacturing and installation of the components, in order to eliminate the impact of tolerances of the components and ensure the reliable connection between the components, the flexible printed circuit 600 is typically used to connect between corresponding components that are spaced apart. By utilizing the bendable and deformable performances of the flexible printed circuit 600, the requirements such as spacing and relative position during component installation are met.

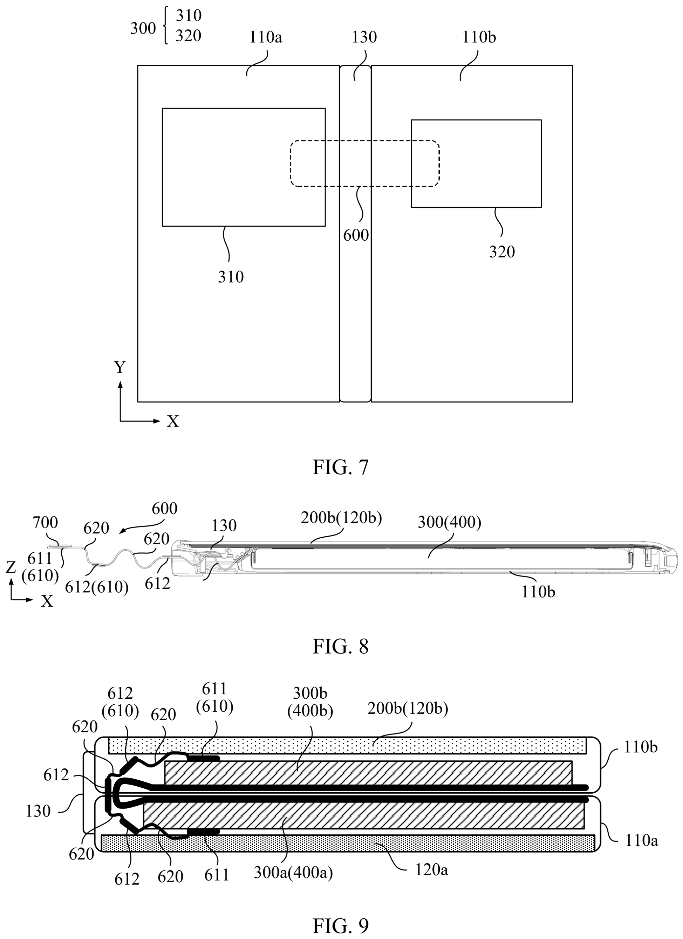

Using a bar-type electronic device as an example, the flexible printed circuit 600 may be used to electrically connect the camera 500 and the circuit board 300 (secondary board 320) integrated with the microphone and the speaker to the circuit board 300 (main board 310) integrated with components such as the system-on-a-chip and the memory. Referring to FIG. 7, the figure shows the electrical connection structure of the foldable electronic device. Using the foldable electronic device as an example, the flexible printed circuit 600 may be used to achieve the electrical connection between the components in the first accommodating cavity and the components in the second accommodating cavity, where a first end of the flexible printed circuit 600 may be connected to the main board 310 (the secondary board 320) attached to the first middle frame 110a, and a second end of the flexible printed circuit 600 may be connected to the secondary board 320 (the main board 310) attached to the second middle frame 110b. Although not shown in the figure, it should be understood that other related components in each accommodating cavity (for example, the camera 500 and other circuit boards 300 provided with components such as the connector, the microphone, and the speaker) may also be electrically connected to the main board 310 (the secondary board 320) in the accommodating cavity through the flexible printed circuit 600.

Whether in the bar-type electronic device or the foldable electronic device, the flexible printed circuit 600 in the electronic device 1 is typically reserved with a certain redundant length, so as to compensate for the tolerances of the relevant components during manufacturing and installation, and to ensure a stable and reliable connection of the components.

FIG. 8 is a diagram of a partial structure of a foldable electronic device according to an embodiment of this application. Referring to FIG. 8, using the foldable electronic device as an example in the figure, the figure shows the structure in which the flexible printed circuit 600 is connected to one of the two relatively rotatable portions of the electronic device 1. An example in which the portion shown in the figure is a side where the second middle frame 110b is located is used, the second end of the flexible printed circuit 600 is connected to the components (for example, the secondary board 320 or the main board 310) installed on the second middle frame 110b, and the first end of the flexible printed circuit 600 passes through the rotating shaft 130 and is connected to the components (for example, the main board 310 or the secondary board 320) on the first middle frame 110a (in conjunction with FIG. 7).

For example, both ends of the flexible printed circuit 600 may be connected to the components installed on the first middle frame 110a and the second middle frame 110b through a BTB (Board-to-Board, board-to-board) connector. For example, a female socket of the BTB connector 700 may be attached to both ends of the flexible printed circuit 600, and a male socket of the BTB connector 700 may be attached to both the main board 310 installed on the first middle frame 110a (or the second middle frame 110b) and the secondary board 320 installed on the second middle frame 110b (or the first middle frame 110a) (in conjunction with FIG. 7). The female socket of the BTB connector 700 is inserted with the male socket of the BTB connector 700 to electrically connect the main board 310 and the secondary board 320 through the flexible printed circuit 600. The flexible printed circuit 600 is provided with at least two fixing portions 610, and each of the fixing portions 610 may be arranged at intervals along the length direction of the flexible printed circuit 600. The fixing portions 610 are fixedly connected inside the electronic device 1 to fix the overall position of the flexible printed circuit 600, thereby achieving a connection between the flexible printed circuit 600 and the relevant components, and ensuring the stability and reliability of the flexible printed circuit 600.

A section of the flexible printed circuit 600 between adjacent fixing portions 610 is a moving section 620. The moving section 620 may move in the electronic device 1, and the moving section 620 is configured to provide the flexible printed circuit 600 with a space for deformation and displacement, so as to enable the flexible printed circuit 600 to compensate for component tolerances. Moreover, for the flexible circuit board 600 applied to the foldable electronic device, a redundant length provided by the moving section 620 is configured to compensate for a moving space of the flexible printed circuit 600, so as to enable the flexible printed circuit 600 to extend or contract along with state transitions of the electronic device 1.

Continuing to refer to FIG. 8, it may be understood that at least the both ends (in the length direction) of the flexible printed circuit 600 are provided with fixing portions 610. For ease of description, in this embodiment, the fixing portions 610 located at the ends of the flexible printed circuit 600 are defined as end fixing portions 611. The end fixing portions 611 at both ends of the flexible printed circuit 600 are respectively configured to connect with corresponding components. An example in which both ends of the flexible printed circuit 600 are connected to corresponding components through BTB connectors 700 is used, the female sockets of the BTB connector 700 may be attached to the end fixing portions 611 at the both ends of the flexible printed circuit 600.

Regarding the foldable electronic device, since the flexible printed circuit 600 needs to pass through the rotating shaft 130 between the first middle frame 110a and the second middle frame 110b, the length of the flexible printed circuit 600 is relatively large. In addition to the end fixing portions 611 at both ends of the flexible printed circuit 600, at least one fixing portion 610 may also be arranged between the both ends of the flexible printed circuit 600. For ease of description, in this embodiment, the fixing portion 610 arranged between the both ends of the flexible printed circuit 600 is defined as a middle fixing portion 612. The middle fixing portion 612 is configured to assist in positioning the section of the flexible printed circuit 600 between its both ends, and to divide the moving section 620 of the flexible printed circuit 600, so as to prevent issues such as stacking, entanglement, wear, or jamming caused by an excessively long moving section 620 of the flexible printed circuit 600, thereby avoiding the impact on the reliability and service life of the flexible printed circuit 600, and preventing the impact on the moving of the electronic device 1.

For example, referring to FIG. 8, three middle fixing portions 612 may be arranged at intervals between the both end fixing portions 610 at both ends of the flexible printed circuit 600. In these three middle fixing portions 612, a middle fixing portion 612 located in the middle may be fixedly connected to the central portion of the rotating shaft 130 (in the width direction, an X direction in FIG. 7), and this middle fixing portion 612 may be functioned to position the flexible printed circuit 600 as a whole. The middle fixing portions 612 at two sides may be connected to the two sides of the rotating shaft 130 in the width direction, respectively, and the moving sections 620 between the middle fixing portions 612 at the two sides and the middle fixing portion 612 in the middle provide sufficient redundant length for the flexible printed circuit 600, thereby meeting the length requirements of the flexible printed circuit 600 when the electronic device 1 is in different states. In addition, the moving sections 620 between the middle fixing portions 612 at the two sides and the end fixing portions 611 at corresponding ends may also have a certain redundant length, so as to compensate for assembly tolerances between the flexible printed circuit 600 and the corresponding components.

Using the bar-type electronic device as an example, when the spacing between the two components connected by the flexible printed circuit 600 is small and the overall length of the flexible printed circuit 600 is small, the flexible printed circuit 600 may be provided with fixing portions 610 only at its both ends. In other words, the flexible printed circuit 600 has end fixing portions 611 only at both ends, and all of the sections between the both ends of the flexible printed circuit 600 is the moving section 620. When the spacing between the two components connected by the flexible printed circuit 600 is large and the overall length of the flexible printed circuit 600 is large, in addition to the two end fixing portions 610 at both ends, at least one middle fixing portion 612 may be arranged between the two ends of the flexible printed circuit 600. The middle fixing portion 612 divides to at least two moving sections 620, so as to limit a moving range of the flexible printed circuit 600 and improving the reliability of the flexible printed circuit 600. Details are not repeated here.

For example, a side surface of these middle fixing portions 612 toward the components (such as the rotating shaft 130) may be attached with support sheets (not shown in the figure), and the support sheets may be metal sheets such as iron sheets, aluminum sheets, or copper sheets, and the middle fixing portions 612 are fixedly connected to the respective portions of the corresponding components by means of the support sheets.

However, whether the flexible printed circuit 600 is applied to the foldable electronic device or the flexible printed circuit 600 is applied to the bar-type electronic device, when the relevant components are installed under good conditions, the redundant length of the flexible printed circuit 600 cannot be effectively utilized. On the contrary, due to the redundancy, the flexible printed circuit 600 may generate phenomena such as accumulating, bending, and arching, which squeezes the adjacent components and cause the issues such as abnormal pressing noise.

The conventional flexible printed circuit 600 has a relatively rigid texture. When the redundant length of the flexible printed circuit 600 is too large, the flexible printed circuit 600 generates a significant bending in the thickness direction of the electronic device 1 (a Z direction in FIG. 8), and the surface of the flexible printed circuit 600 will squeeze the adjacent components. The portions of the electronic device 1 squeezed by the flexible printed circuit 600 bear a relatively high pressure, so that the portions may generate the issues such as abnormal pressing noise.

FIG. 9 is a schematic diagram of an installation condition of a flexible printed circuit. Referring to FIG. 9, an example in which the flexible printed circuit 600 is applied to the foldable electronic device is used, especially for the moving sections 620 of the flexible printed circuit 600 near its two ends, since the ends of the flexible printed circuit 600 are connected to the components in the electronic device 1, the thicknesses of the components themselves (together with the additional thickness of the BTB connector 700) occupy a relatively large thickness space of the electronic device 1, limiting the moving space of the moving sections 620 of this section in the thickness direction of the electronic device 1, and causing the two sides of the moving sections 620 to squeeze the adjacent components.

For example, for the moving section 620 near the first end of the flexible printed circuit 600, one side surface of the moving section 620 squeezes the first rear cover 120a, and another side surface of the moving section 620 squeezes the main board 310 (the secondary board 320) or the battery 400 (main battery 410) located beside the main board 310 (the secondary board 320). For the moving section 620 near the second end of the flexible printed circuit 600, one side surface of the moving section 620 squeezes the second display screen 200b (or the second rear cover 120b), and another side surface of the moving section 620 squeezes the secondary board 320 (the main board 310) or the battery 400 (secondary battery 420) located beside the secondary board 320 (the main board 310). In this way, issues such as abnormal pressing noise may occur in the electronic device 1, and during long-term use, the reliability and service life of the flexible printed circuit 600 may also be affected.

When the inward-folding electronic device is equipped with the second display screen 200b, the flexible printed circuit 600 squeezes the second display screen 200b, causing the second display screen 200b to be subjected to a relatively large localized stress, causing the second display screen 200b to exhibit phenomena such as localized bulging and unevenness, and leading to the second display screen 200b to generate a film printing defect. The film printing phenomenon of the second display screen 200b becomes particularly apparent when in a black screen state.

Of course, for the section of the flexible printed circuit 600 located in the region of the rotating shaft 130, even if the moving section 620 of this section has a relatively large moving space, when the redundant length of the moving section 620 is relatively large, the moving section 620 may, at its maximum degree of bending, squeezes the rotating shaft 130 or the first display screen 200a, leading to undesirable phenomena in the electronic device 1 such as abnormal noise (during switching use state), abnormal pressing noise, and film printing.

For the flexible printed circuit 600 applied to the bar-type electronic device, the moving sections 620 of the flexible printed circuit 600 (particularly near its two ends) may also occur phenomena such as squeezing the adjacent components due to a limited moving space, when the redundant length of the flexible circuit board 600 is too large, thereby causing issues such as abnormal pressing noise in the electronic device 1, and during long-term use, the reliability and service life of the flexible printed circuit 600 may also be affected. Details are not repeated here.

In view of this, the embodiment of this application improves the flexible printed circuit 600 by providing the dividing groove on at least one moving section 620 of the flexible printed circuit 600. By utilizing the dividing groove, the moving section 620 is divided into the first portion and the second portion along the width direction of the flexible printed circuit 600. The dividing groove may absorb the deformation generated when the flexible printed circuit 600 is bent, and the first portion and the second portion are completely divided and do not affect each other, reducing the deformation of the first portion and the second portion, and reducing the overall arching degree of the flexible printed circuit 600, and reducing the pressure exerted by the flexible printed circuit 600 on the adjacent components. As a result, the issues such as abnormal pressing noise and film printing of the electronic device 1 can be improved.

Hereinafter, an example in which the flexible printed circuit 600 is applied to the foldable electronic device and passes through the rotating shaft 130 is used, and the flexible printed circuit 600 provided in this embodiment will be described in detail.

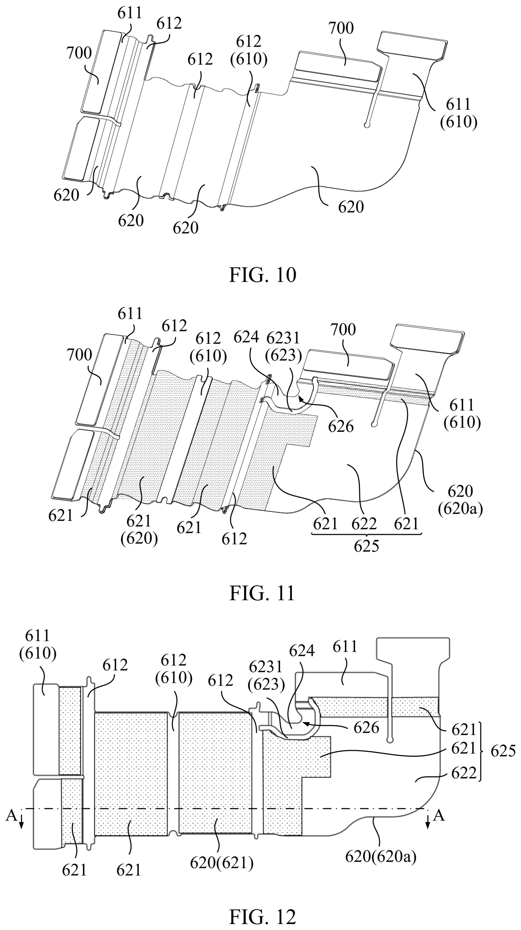

FIG. 10 is a schematic structural diagram of a flexible printed circuit in a related technology. Referring to FIG. 10, the figure shows a conventional structure of the flexible printed circuit 600. As shown in the figure, BTB connectors 700 (for example, female sockets) are attached to the end fixing portions 611 at both ends of the flexible printed circuit 600 to achieve the connection between the flexible printed circuit 600 and the corresponding components. Three middle fixing portions 612 are arranged at intervals between the end fixing portions 611 at the two ends of the flexible printed circuit 600, and as previously described, these three middle fixing portions 612 are respectively configured to be fixedly connected to different portions of the rotating shaft 130.

For example, the figure shows that the end fixing portions 611 at both ends of the flexible printed circuit 600 are divided into two portions, and the two portions of end fixing portions 611 are each attached with the BTB connector 700. This may achieve dual-interface connection between the ends of the flexible printed circuit 600 and the corresponding components, so as to meet the functional requirements of multi-signal transmission between the components.

In the related technology, the moving section 620 between the adjacent fixing portions 610 of the flexible printed circuit 600 typically have an integral structure. That is to say, the moving section 620 has an inseparable whole-layer structure in the thickness direction. Based on the fixing portions 610 of the flexible printed circuit 600 typically having the whole-layer structure, the entire flexible printed circuit 600 is an inseparable integral structure. Regarding the flexible printed circuit 600 having a certain thickness, the hardness of the flexible printed circuit 600 with the integral structure is relatively high, resulting in a relatively large arc radius after the flexible printed circuit 600 is bent. When the flexible printed circuit 600 abuts against the adjacent components (for example, the rear cover 120 or the display screen 200)in the thickness direction (the Z direction in FIG. 8) of the electronic device 1, a relatively large jacking force is exerted to the corresponding components, causing the issues such as abnormal pressing noise and film printing occurred in the electronic device 1.

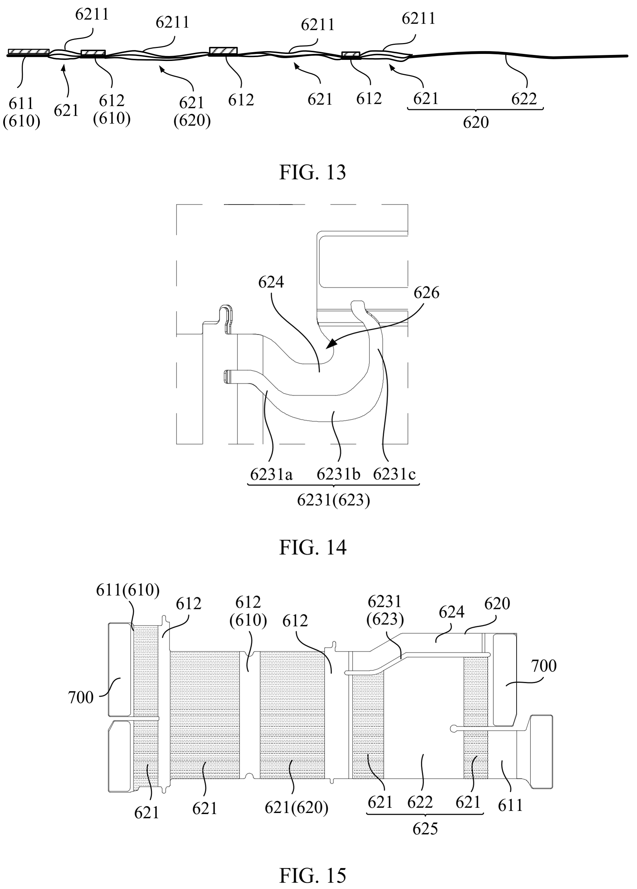

FIG. 11 is a schematic structural diagram of another flexible printed circuit according to an embodiment of this application. FIG. 12 is a schematic structural diagram of the flexible printed circuit shown in FIG. 11 in an unfolded state. FIG. 13 is a schematic cross-sectional diagram along A-A in FIG. 12.

Referring to FIG. 11 and FIG. 12, in this embodiment, at least one moving section 620 of each moving section 620 of the flexible printed circuit 600 may be provided with a dividing groove 623, and the dividing groove 623 avoids the wiring in the flexible printed circuit 600 and does not affect signal transmission of the flexible printed circuit 600.

By providing the dividing groove 623 in the moving section 620, the dividing groove 623 may absorb the bending deformation of the moving section 620 caused by the redundant length, releasing a deformation stress of the moving section 620, weakening the bending deformation of the moving section 620, and improving an interference phenomenon of the moving section 620 with the adjacent components, thereby improving the issues such as abnormal pressing noise and film printing of the electronic device 1, and improving a using performance of the electronic device 1.

For the moving section 620 provided with the dividing groove 623, the dividing groove 623 divides the moving section 620 into the first portion 624 and the second portion 625 along the width direction of the moving section 620. The division by the dividing groove 623 makes the first portion 624 and the second portion 625 not affect each other. Accordingly, specific structures of the first portion 624 and the second portion 625 may be designed, respectively, thereby further improving the issue of interference of the moving section 620 with the adjacent components.

Continuing to refer to FIG. 11 or FIG. 12, based on at least one moving section 620 of the flexible printed circuit 600 being provided with the dividing groove 623, in this embodiment, at least some moving sections 620 of all moving sections 620 of the flexible printed circuit 600 are provided with a multilayer section 621. Referring to FIG. 13, the multilayer section 621 includes at least two structural layers 6211 arranged along the thickness direction of the flexible printed circuit 600, where each of the structural layers 6211 is stacked in the thickness direction of the moving section 620, and each of the structural layers 6211 is separated from each other.

The multilayer section 621 divides the moving section 620 into two or more structural layers 6211 along its thickness direction, so that the overall moving section 620 is formed by two or more structural layers 6211 with a small thickness. Since each of the structural layers 6211 has a relatively small thickness and an air layer is formed between adjacent structural layers 6211 that are separated from each other, each of the structural layers 6211 can move without being constrained by the other structural layers 6211. Further, the presence of the multilayer section 621 reduces the hardness of the moving section 620, making the moving section 620 softer and easier to bend. This can effectively reduce the jacking force exerted by the moving section 620 on adjacent components, and improve the issues such as abnormal pressing noise and film printing of the electronic device 1.

An example in which the flexible printed circuit 600 is applied to the foldable electronic device is used, when the flexible printed circuit 600 includes a plurality of moving sections 620, that is, when at least one middle fixing portion 612 is provided between the end fixing portions 611 at both ends of the flexible printed circuit 600, either some of the moving sections 620 may be provided with the multilayer section 621, or all of the moving sections 620 may be provided with the multilayer section 621. An example in which the flexible printed circuit 600 is applied to the bar-type electronic device, when the flexible printed circuit 600 includes one moving section 620, this moving section 620 may be provided with the multilayer section 621. When the flexible printed circuit 600 is provided with two or more moving sections 620 arranged at intervals, at least one of the moving sections 620 may be provided with the multilayer section 621.

For example, whether the flexible printed circuit 600 is applied to the foldable electronic device, or the flexible printed circuit 600 is applied to the bar-type electronic device, the moving section 620 located in the middle region of the flexible printed circuit 600 along the length direction of the flexible printed circuit 600 typically has a greater bending degree. Therefore, the multilayer section 621 may be provided on the moving section 620 in the middle region to ensure the bending performance of the moving section 620 in the middle region. Based on the multilayer section 621 being provided on the moving section 620 of the middle region, the multilayer sections 621 may also be provided on the moving sections 620 near the ends of the flexible printed circuit 600. The moving sections 620 near the ends of the flexible printed circuit 600 typically have a relatively small moving space. By providing the multilayer sections 621 on the moving sections 620 near the ends, the harness of the movable sections 620 may be reduced, and the jacking force exerted by the moving sections 620 on adjacent components may be lowered.

Specifically, an example in which three middle fixing portions 612 are arranged at intervals between the end fixing portions 611 at both ends of the flexible printed circuit 600, the multilayer section 621 may be provided only on the moving section 620 between the adjacent middle fixing portions 612. The region between the middle fixing portions 612 corresponds to the moving region of the rotating shaft 130, where the moving section 620 in this region has a relatively large moving range along with the rotation of the rotating shaft 130. By providing the multilayer section 621 on the moving section 620 in this region, the moving section 620 in this region becomes more flexible, ensuring the bending performance of the moving section 620 in this region. Moreover, since the moving section 620 in this region has a relatively large moving range of, the moving section 620 in this region is typically provided with a relatively large redundant length to meet moving requirements of the moving section 620 in this region. By providing the multilayer section 621 on the moving section 620 in this region, when the moving section 620 squeezes the adjacent components (for example, members of the rotating shaft 130), the jacking force exerted by the moving section 620 on the components may also be reduced.

To compensate for the tolerances of the components during manufacturing and installation, the moving section 620 between the end fixing portion 611 and the middle fixing portion 612 adjacent thereto of the flexible printed circuit 600 is also typically designed with a certain redundant length. Moreover, since at least a portion of the moving section 620 in this region is supported on installing components (for example, the circuit board 300), the moving space of the moving section 620 in this region is smaller. Therefore, referring to FIG. 12 and FIG. 13, based on the multilayer section 621 being provided on the moving section 620 between adjacent middle fixing portions 612, the multilayer section 621 may also be provided on the moving section 620 between the end fixing portion 611 and the middle fixing portion 612 adjacent thereto, so as to improve the flexibility of the moving section 620 in this region and reduce the jacking force exerted by the moving section 620 in this region on the components.

For the moving section 620 between the end fixing portion 611 and the middle fixing portion 612 adjacent thereto of the flexible printed circuit 600, since the moving section 620 typically has only the requirement of redundant length, without the requirement of bending or unfolding along with the movement of the rotating shaft 130, the multilayer section 621 may be provided only in a portion of the region of the moving section 620 along the length direction of the moving section 620, while the remaining region of the moving section 620 is an integrated section 622, or the multilayer section 621 may also occupy the entire region of the moving section 620.

The so-called integrated section 622 refers to the moving section 620 in this section that is an integral whole in the thickness direction without layering. As for the construction of the integrated section 622, in some examples, the integrated section 622 may be an integrally formed structure, and the integrated section 622 and the multilayer section 621 may be formed by different forming processes and connected together. In other examples, the integrated section 622 may also be formed of a plurality of structural layers 6211, where adjacent structural layers 6211 may be adhered together to form an integral whole.

Referring to FIG. 11 or FIG. 12. For example, for the moving section 620 between the end fixing portion 611 and the middle fixing portion 612 adjacent thereto of the flexible printed circuit 600, when the moving section 620 is relatively narrow (along the length direction of the flexible printed circuit 600), the multilayer section 621 may occupy the entire region of the moving section 620 along the length direction of the flexible printed circuit 600. When the moving section 620 is relatively wide (along the length direction of the flexible printed circuit 600), the multilayer section 621 may occupy only a portion of the region of the moving section 620 along the length direction of the flexible printed circuit 600. For example, the region of the moving section 620 near the fixing portions 610 on two sides may be provided with the multilayer sections 621, and the middle region may be provided with the integrated section 622, where the moving section 620 is formed by the multilayer sections 621 on two sides and the integrated section 622 in the middle.

It should be noted that the multilayer section 621 described herein occupies a portion of the region or the entire region of the moving section 620 with respect to the length direction of the flexible printed circuit 600, rather than the entire region of the moving section 620, so as to indicate the size of the region of the moving section 620 occupied by the multilayer section 621 along the length direction of the flexible printed circuit 600.

As for the moving section 620 provided with the dividing groove 623, the first portion 624 located on one side of the dividing groove 623 may be an integrated portion, where the integrated portion is similar to the integrated section 622 as described above, and the integrated portion is an integral whole without layering in the thickness direction of the moving section 620. At least a portion of the region of the second portion 625 located on another side of the dividing groove 623 is the multilayer section 621 as described above.

The dividing groove 623 completely divides the moving section 620 into a first portion 624 and a second portion 625 (in the width direction), and the first portion 624 and the second portion 625 do not affect each other. By designing the first portion 624 as the integrated portion, the overall hardness of the first portion 624 is relatively higher, an ability to resist deformation of the first portion 624 is better, and an arching degree of the first portion 624 is smaller, which may weaken the interference between the first portion 624 and adjacent components, and even prevent the first portion 624 from contacting the adjacent components, so as to avoid squeezing the adjacent components. By providing the multilayer section 621 in the second portion 625, the small hardness of the multilayer section 621 is reduced, and the flexibility of the multilayer section 621 is better. The multilayer section 621 can fully exhibit its flexible characteristics without the constraint of the first portion 624, reducing the pressure on the adjacent components.

Therefore, by providing the dividing groove 623 on the moving section 620, the dividing groove 623 divides the moving section 620 into the first portion 624 and the second portion 625 along the width direction. By providing the first portion 624 as the integrated portion and providing the multilayer section 621 in the second portion 625, the dividing groove 623 may absorb the deformation of the moving section 620, reducing the stress generated by the deformation of the moving section 620, and weakening the overall arching degree of the moving section 620. Moreover, the dividing groove 623 isolates the impact between the first portion 624 and the second portion 625, enabling the first portion 624 to exhibit its characteristics of higher hardness, smaller arching, and little interference with the adjacent components, and allowing the multilayer section 621 of the second portion 625 to exhibit its characteristics of greater flexibility and small jacking force on the adjacent components. As a result, the issues such as abnormal pressing noise and film printing of the electronic device 1 are improved, improving the using performance of the electronic device 1.

In addition, when designing a wiring structure of the flexible printed circuit 600, the radio frequency signal lines may be partially or even entirely distributed in the first portion 624. In other words, a position of the dividing groove 623 may be arranged according to distribution regions of the radio frequency signal lines, so that most or even all of the radio frequency signal lines are distributed in the first portion 624. By providing the first portion 624 as the integrated portion, the performance of the radio frequency signal lines can be ensured, avoiding radio frequency signal loss, and contributing to improve the communication efficiency and the call quality of the electronic device 1.

As for a distribution position of the dividing groove 623 on the flexible printed circuit 600, as described above, the portions of the flexible printed circuit 600 near its two ends typically have relatively small moving space, and the spacing between the moving section 620 near the end of the flexible printed circuit 600 and the adjacent components is smaller. Therefore, the dividing groove 623 may be provided in the moving section 620 between the end fixing portion 611 and the adjacent middle fixing portion 612 of the flexible printed circuit 600, so as to weaken the arching degree of the moving section 620 of the flexible printed circuit 600 near the end region, improve the interference between the moving section 620 in this region and the adjacent components, and improve the issues such as abnormal pressing noise and film printing in the electronic device 1.

As shown in FIG. 11 or FIG. 12, the dividing groove 623 may be provided only on the moving section 620 at one end of the flexible printed circuit 600. For example, the dividing groove 623 may be provided on the moving section 620 that is relatively wide (in the length direction of the flexible printed circuit 600), while the moving section 620 that is relatively narrow (in the length direction of the flexible printed circuit 600) may not be provided with the dividing groove 623, since its deformation is relatively small. Of course, the dividing groove 623 may also be provided on the moving sections 620 at both ends of the flexible printed circuit 600.

Using the moving section 620 that is relatively wide (in the length direction of the flexible printed circuit 600) and near one end of the flexible printed circuit 600 as an example, in the second portion 625 of this moving section 620 divided and formed by the dividing groove 623, the regions near two sides of the second portion 625 may be provided with multilayer sections 621, and the middle region of the second portion 625 may be the integrated section 622.

For the moving sections 620 in the middle region of the flexible printed circuit 600, that is, the moving sections 620 formed between adjacent middle fixing portions 612, since these moving sections 620 (for example, the sections of the flexible printed circuit 600 corresponding to the rotating shaft 130) typically have a relatively large moving space, the deformation space requirements of the moving sections 620 may be met. Therefore, the dividing groove 623 may not be provided on these moving sections 620 (as shown in FIG. 11 or FIG. 12). For example, the entire moving section 620 may be a multilayer section 621. Of course, in some examples, the dividing groove 623 may also be provided on these moving sections 620, where one portion of the moving section 620 is the integrated section 622 and another portion is the multilayer section 621. This is not limited in this embodiment.

Continuing to refer to FIG. 11 or FIG. 12, the dividing groove 623 includes a main groove section 6231. An extending direction of the main groove section 6231 forms an angle with the width direction of the flexible printed circuit 600. In other words, the main groove section 6231 extends in a direction inclined to the width direction of the flexible printed circuit 600, and the main groove section 6231 extends to both ends of the moving section 620. For example, the two ends of the main groove section 6231 respectively extend to the fixing portions 610 at both ends of the moving section 620. In this way, the main groove section 6231 may divide the moving section 620 into the first portion 624 and the second portion 625 along the width direction of the flexible printed circuit 600.

In order to avoid the hardness of the first portion 624 becoming too high, in this embodiment, along the width direction of the flexible printed circuit 600, a width occupied by the first portion 624 may be relatively small, and a width occupied by the second portion 625 may be relatively large, so as to ensure the overall bending performance of the moving section 620 provided with the dividing groove 623. Based on reducing the arching degree of the first portion 624, when the first portion 624 presses against the adjacent components, the jacking force exerted by the first portion 624 on the adjacent components is reduced by maintaining a smaller width for the first portion 624.

For ease of description, this embodiment defines the two sides of the flexible printed circuit 600 in the width direction as a first side and a second side, respectively. The main groove section 6231 of the dividing groove 623 may be arranged near the first side of the flexible printed circuit 600, and the first portion 624 may be located between the first side of the flexible printed circuit 600 and the main groove section 6231 of the dividing groove 623, in other words, the width occupied by the first portion 624 is relatively small, and the width occupied by the second portion 625 is relatively large. The first side of the flexible printed circuit 600 may be a side where the radio frequency signal lines are concentrated, so that a portion or even all of the radio frequency signal lines are located in the first portion 624.

Considering that a routing in the flexible printed circuit 600 generally extends along its length direction, in this embodiment, at least a portion of the main groove section 6231 of the dividing groove 623 may extend along the length direction of the flexible printed circuit 600. In this way, in the width direction of the flexible printed circuit 600, the space occupied by the main groove section 6231 of the dividing groove 623 is very small, and an interference with a routing path of the wiring in the flexible printed circuit 600 is relatively small. The wiring in the flexible printed circuit 600 may also maintain a routing path generally along the length direction of the flexible printed circuit 600, and the wiring in the flexible printed circuit 600 is relatively uniform, which may reduce signal interference and improve the signal transmission performance of the flexible printed circuit 600.

For example, an extending shape of the main groove section 6231 of the dividing groove 623 may be designed according to an extending shape of the moving section 620 (where the dividing groove 623 is located) and the wiring layout within the moving section 620. It may be that a portion of the main groove section 6231 extends along the length direction of the flexible printed circuit 600, or that the entire main groove section 6231 extends along the length direction of the flexible printed circuit 600.

In addition, referring to FIG. 14, the figure shows local enlarged structure of the flexible printed circuit 600 at another portion of the dividing groove 623. In some implementations, the width of the main groove section 6231 may be designed with variations. For example, along the length direction of the main groove section 6231, the main groove section 6231 may include a first section 6231a, a middle section 6231b, and a second section 6231c connected in sequence. The first section 6231a and the second section 6231c are located at the two ends of the main groove section 6231, and the middle section 6231b is located between the first section 6231a and the second section 6231c. A maximum width of the first section 6231a and a maximum width of the second section 6231c are both smaller than a minimum width of the middle section 6231b. The main groove section 6231 is designed in a structure that is wide in the middle and narrow at both ends. Based on ensuring that the main groove section 6231 has a sufficient area, the width of the middle region of the main groove section 6231 is increased, enhancing an ability of the main groove section 6231 to absorb a bending deformation of the moving section 620, enabling better release of stress from the moving section 620, and reducing the arching degree of the moving section 620.

For example, along the length direction of the main groove section 6231, the width of the main groove section 6231 may gradually decrease from a center of the main groove section 6231 toward an edge of the main groove section 6231. That is to say, the width of the main groove section 6231 in a way that varies gradually, avoiding a step difference at a connecting portion between the first section 6231a and the middle section 6231b, and at a connecting portion between the second section 6231c and the middle section 6231b. This prevents reliability issues such as local tearing and breakage caused by the step difference under long-term or repeated bending.

FIG. 12 and FIG. 14 show a case where the flexible printed circuit 600 includes a bending section 620a. At least one of the moving sections 620 of the flexible printed circuit 600 is the bending section 620a. That is to say, along a planar direction of the flexible printed circuit 600, the moving section 620 of the flexible printed circuit 600 bends toward one side, and the moving section 620 forms a corner at the bending portion. With respect to the first side and second side of the flexible printed circuit 600 as defined above in the width direction, the moving section 620 may bend toward a direction where the first side is located.

In this regard, the moving section 620 formed as the bending section 620a with the corner may be provided with the dividing groove 623. This moving section 620 bends toward the first side of the flexible printed circuit 600, and a corner portion of the moving section 620 is located at the first side of the flexible printed circuit 600. By configuring the first portion 624 between the first side of the flexible printed circuit 600 and the dividing groove 623 as an integrated portion, that is, configuring the corner portion of the moving section 620 as the integrated portion, the dividing groove 623 may absorb a bending deformation of the corner portion, and the hardness of the corner portion is relatively higher, which may weaken the arching degree at the corner portion, thereby reducing a contact area between the corner portion and the adjacent components, or even making the corner portion not in contact with the adjacent components. This reduces or even eliminates a jacking force exerted by the corner portion on the adjacent components, improving the issues such as abnormal pressing noise and film printing of the electronic device 1.

Referring to FIG. 12 or FIG. 14, for the main groove section 6231 of the dividing groove 623 that extends generally along the length direction of the flexible printed circuit 600, the extending shape of the main groove section 6231 may match the bending shape of the corner portion of the bending section 620a. An example in which a bending angle of the bending section 620a is approximately 90° is used, a central angle corresponding to the corner portion of the bending section 620a is approximately 90°. Correspondingly, the main groove section 6231 of the dividing groove 623 may be generally formed as an arc-shaped structure of a quarter circle.

In some embodiments, the corner region of the bending section 620a may be designed with a crack arrest groove 626. The crack arrest groove 626 is an inwardly extending groove structure formed at the corner portion, based on a curvature of the corner portion matched to a bending, by removing additional material from the corner portion so that a boundary of the corner portion is recessed and a notch area of the corner portion is enlarged. With this design, a portion of the material at the corner portion is removed, which helps improve material accumulation at the corner portion and avoids a cracking of the flexible printed circuit 600 caused by a severe stacking at the corner portion.

In this regard, to match the crack arrest groove 626 at the corner portion of the bending section 620a, a corresponding portion of the main groove section 6231 of the dividing groove 623 corresponding to the crack arrest groove 626 may also be offset inward, so as to ensure that there is sufficient spacing between the main groove section 6231 and the crack arrest groove 626, which prevents the first portion 624 from becoming locally too narrow at the position of the crack arrest groove 626, thereby ensuring the reliability of the first portion 624. For example, the middle section of the main groove section 6231 of the dividing groove 623 protrudes in a direction away from the corner portion, and the main groove section 6231 is formed into a structure similar to a shape of a letter "C".

FIG. 15 is a schematic structural diagram of a third flexible printed circuit in an unfolded state according to an embodiment of this application. Referring to FIG. 15, the figure shows a case where the flexible printed circuit 600 has no obvious bending section 620a and extends in a substantially straight line. In this case, for the moving section 620 provided with the dividing groove 623, for example, the moving section 620 near the end of the flexible printed circuit 600, the extending shape of the dividing groove 623 may match a shape of a side edge of the flexible printed circuit 600 on the adjacent side. For the aforementioned manner where the dividing groove 623 is arranged near the first side of the flexible printed circuit 600, the extending shape of the dividing groove 623 may match the shape of the side edge of the first side of the flexible printed circuit 600, such that the dividing groove 623 divides to form the first portion 624 with a good width consistency and a high reliability.

Using the example shown in FIG. 15, from the end fixing portion 611 of the flexible printed circuit 600 to the adjacent middle fixing portion 612, the first side of the flexible printed circuit 600 includes a straight section, an inclined section (inclined inward from outside), and a straight section connected in sequence. To match the above, the dividing groove 623 may also include a straight section, an inclined section (inclined inward from outside), and a straight section connected in sequence.

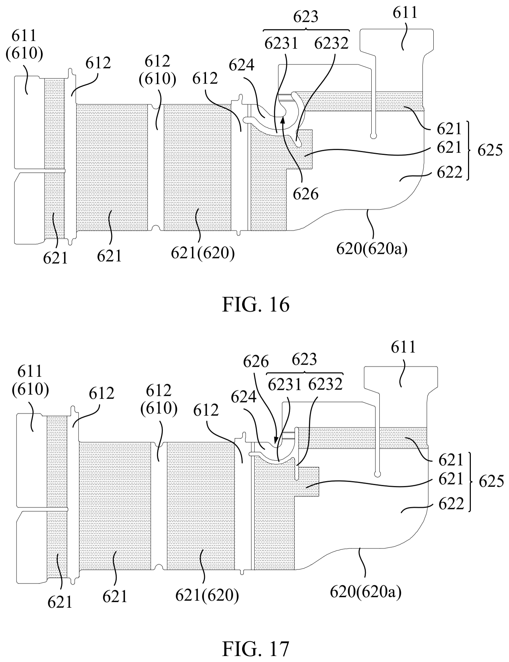

FIG. 16 is a schematic structural diagram of a fourth flexible printed circuit in an unfolded state according to an embodiment of this application. FIG. 17 is a schematic structural diagram of a fifth flexible printed circuit in an unfolded state according to an embodiment of this application.

Referring to FIG. 16 and FIG. 17, in some embodiments, based on the main groove section 6231, the dividing groove 623 is further provided with a branch groove section 6232. The branch groove section 6232 intersects with the main groove section 6231 and the branch groove section 6232 is in communication with the main groove section 6231, together forming the dividing groove 623. In this way, the area of the dividing groove 623 is increased, and since the branch groove section 6232 and the main groove section 6231 have an intersection portion, the ability of the dividing groove 623 to absorb a bending deformation of the moving section 620 is enhanced. The main groove section 6231 and the branch groove section 6232 can absorb stresses from different directions and disperse the stresses, thereby better releasing the stress of the moving section 620, reducing the arching degree of the moving section 620, weakening the jacking force exerted by the moving section 620 on the adjacent components, and improving the issues such as abnormal pressing noise and film printing of the electronic device 1.

As described above, in the case where the width of the first portion 624 is relatively small, the branch groove section 6232 may be arranged in the second portion 625, where one end of the branch groove section 6232 toward the main groove section 6231 is in communication with the main groove section 6231 and another end of the branch groove section 6232 extends in a direction away from the main groove section 6231. In this way, the branch groove section 6232 does not occupy the space of the first portion 624, thereby preventing the first portion 624 from becoming locally too narrow and avoiding the impact on the reliability of the first portion 624. Of course, in the case where the first portion 624 is relatively wide, if the reliability of the first portion 624 would not be affected, the branch groove section 6232 may also extend from the second portion 625 into a region where the first portion 624 is located, or the branch groove section 6232 may even be entirely located in the first portion 624. This is not limited in this embodiment.

Referring to FIG. 16, in some examples, the branch groove section 6232 may be connected to the middle portion of the main groove section 6231, and the branch groove section 6232 extends in a direction away from the main groove section 6231. The branch groove section 6232 may extend into the multilayer section 621, or the branch groove section 6232 may extend into the integrated section 622. Referring to FIG. 17, in some other examples, the branch groove section 6232 may be connected to the end portion of the main groove section 6231. Since the end portion of the main groove section 6231 extends to the fixing portion 610 on one side of the moving section 620, the branch groove section 6232 may extend into the region where the moving section 620 is located. The branch groove section 6232 may extend into the multilayer section 621, or the branch groove section 6232 may extend into the integrated section 622.

FIG. 16 and FIG. 17 show that the dividing groove 623 is provided on the moving section 620 that forms the bending section 620a. To match the bending portion of the bending section 620a, the main groove section 6231 of the dividing groove 623 is similar to an arc-shaped section. In this case, when the branch groove section 6232 is located in the second portion 625 and one end thereof is connected to the middle portion of the main groove section 6231, the dividing groove 623 formed is similar to a "Y" shape (see FIG. 16). When the branch groove section 6232 is located in the second portion 625 and connected to one end of the main groove section 6231, specifically in an example in which the branch groove section 6232 extends from the end of the main groove section 6231 along a tangential direction of the main groove section 6231, the dividing groove 623 formed is similar to a "T" shape (see FIG. 17).

As for a depth to which the dividing groove 623 extends in the thickness direction of the flexible printed circuit 600, in one embodiment, the dividing groove 623 may penetrate through two side surfaces in the thickness direction of the flexible printed circuit 600. For the multilayer section 621, this means that the dividing groove 623 penetrates through all of the structural layers 6211 of the multilayer section 621. In this way, the dividing groove 623 completely divides the first portion 624 and the second portion 625, where the bending and deformation of the first portion 624 and the second portion 625 each are not affected at all. This may completely isolate the impact of the relatively rigid first portion 624 on the multilayer section 621 of the second portion 625, allowing the multilayer section 621 of the second portion 625 to fully exhibit its flexible characteristics.

As another embodiment, the dividing groove 623 may not completely penetrate through the two side surfaces in the thickness direction of the flexible printed circuit 600. An example in which the multilayer section 621 includes N (N is an integer ≥ 2) layers is used, the dividing groove 623 may penetrate through N-1 layers of the multilayer section 621, where a bottom layer of the multilayer section 621 is connected together with the first portion 624. The bottom layer of the multilayer section 621 is defined according to a bending direction of the moving section 620. An example in which the moving section 620 bends toward a first direction is used, along the first direction, one structural layer 6211 located at the bottommost position of the multilayer section 621 is defined as the bottom layer, and all of the structural layers 6211 stacked on this bottom layer are defined as stacked layers, where the dividing groove 623 penetrates through the all of the stacked layers of the multilayer section 621, and the bottom layer connects together with the first portion 624. For example, the bottom layer may be integrally formed with the first portion 624.

Specifically, for the moving section 620 located near the end of the flexible printed circuit 600, an example in which the moving section 620 is attached onto the surface of the circuit board 300 is used, this moving section 620 typically bends in a direction away from the circuit board 300. In this case, the first direction is the direction away from the circuit board 300, the bottom layer of the multilayer section 621 is one structural layer 6211 closest to the circuit board 300, and the layers above the bottom layer are all of the stacked layers. One structural layer 6211 of the multilayer section 621 closest to the circuit board 300 is connected to the first portion 624, and the dividing groove 623 penetrates through the remaining stacked layers.

By connecting the bottom layer of the multilayer section 621 together with the first portion 624, the dividing groove 623 penetrates only through each of the stacked layers of the multilayer section 621. In each of the structural layers 6211 of the multilayer section 621, only the moving of its bottom layer is affected by the first portion 624, and since the first portion 624 has relatively higher hardness, the first portion 624 may correspondingly reduce the arching degree of the bottom layer of the multilayer section 621. Each of the stacked layers above the bottom layer of the multilayer section 621 may move freely, and each structural layer 6211 of the multilayer section 621 remains separated from each other. The multilayer section 621 can still fully exhibit its flexible characteristics, and still reduce the jacking force exerted by the multilayer section 621 on the adjacent components, addressing the issues such as abnormal pressing noise and film printing of the electronic device 1.

In the description of the embodiments of this application, it should be noted that, unless otherwise explicitly specified and defined, the terms "install", "connect", and "connection" should be understood in a broadest sense, for example, may be a fixed connection, an indirect connection by using an intermediate medium, or communication inside two elements or an interactive relationship between two elements. A person of ordinary skill in the art may understand specific meanings of the foregoing terms in the embodiments of this application according to a specific situation.

The terms such as "first", "second", "third", and "fourth" (if any) in the description and claims of this application and in the accompanying drawings are used for distinguishing similar objects and not necessarily used for describing any particular order or sequence.

## Claims

1. A flexible printed circuit, configured to be installed in an electronic device and comprising at least one moving section arranged along a length direction of the flexible printed circuit, and the at least one moving section being movable in the electronic device; wherein the at least one moving section is provided with a dividing groove, and the dividing groove divides the moving section into a first portion and a second portion along a width direction of the flexible printed circuit.

2. The flexible printed circuit according to claim 1, wherein the first portion is an integrated portion, and at least a portion of the second portion is a multilayer section, and wherein the multilayer section comprises at least two structural layers arranged along a thickness direction of the flexible printed circuit, and the structural layers are separated from each other.

3. The flexible printed circuit board according to claim 2, wherein a plurality of radio frequency signal lines are arranged in the flexible printed circuit, and at least a portion of the radio frequency signal lines are distributed to the first portion.

4. The flexible printed circuit according to any one of claims 1 to 3, wherein the dividing groove comprises a main groove section, and wherein an extending direction of the main groove section forms an angle with the width direction of the flexible printed circuit, and the main groove section extends to both ends of the moving section.

5. The flexible printed circuit according to claim 4, wherein two sides of the flexible printed circuit in the width direction are configured as a first side and a second side, respectively, and wherein the main groove section is located near the first side, and the first portion is located between the first side and the main groove section.

6. The flexible printed circuit according to claim 4, wherein at least a portion of the main groove section extends along the length direction of the flexible printed circuit.

7. The flexible printed circuit according to claim 4, wherein the dividing groove further comprises at least one branch groove section, and the branch groove section intersects with and communicates with the main groove section.

8. The flexible printed circuit according to claim 7, wherein the branch groove section is located in the second portion, and wherein one end of the branch groove section communicates with the main groove section, and another end of the branch groove section extends in a direction away from the main groove section.

9. The flexible printed circuit according to claim 8, wherein the branch groove section is connected to a middle portion of the main groove section.

10. The flexible printed circuit according to claim 8, wherein the branch groove section is connected to an end of the main groove section.

11. The flexible printed circuit according to claim 10, wherein the main groove section is an arc-shaped section, and the branch groove section extends along a tangential direction of the main groove section.

12. The flexible printed circuit according to claim 4, wherein the at least one moving section provided with the dividing groove is a bending section, and the bending section bends toward a side where the first portion is located.

13. The flexible printed circuit according to claim 12, wherein a corner portion of the bending section is provided with a crack arrest groove, and an extending shape of the main groove section matches a shape of the crack arrest groove.

14. The flexible printed circuit according to any one of claims 1 to 3, further comprising at least two fixing portions, wherein each of the fixing portions is arranged at intervals along the length direction of the flexible printed circuit, the fixing portions are configured to be fixedly connected to components of the electronic device, and the moving section is located between adjacent fixing portions.

15. The flexible printed circuit according to claim 14, wherein the at least two fixing portions comprise two end fixing portions and at least one middle fixing portion, and wherein the two end fixing portions are located at both ends of the flexible printed circuit, respectively, the end fixing portions are configured to connect with the components in the electronic device, and the middle fixing portion is located between the two end fixing portions;
wherein the moving section between at least one of the end fixing portions and the adjacent middle fixing portion is provided with the dividing groove.

16. The flexible printed circuit according to claim 15, wherein in the moving section provided with the dividing groove and located between the end fixing portion and the middle fixing portion, two side regions of the second portion are multilayer sections, and a middle region thereof is an integrated section.

17. The flexible printed circuit according to claim 15, wherein the moving section between the adjacent middle fixing portions is the multilayer section.

18. The flexible printed circuit according to claim 4, wherein along the extending direction of the main groove section, the main groove section comprises a first section, a middle section, and a second section connected in sequence, and a maximum width of the first section and a maximum width of the second section are both smaller than a minimum width of the middle section.

19. The flexible printed circuit according to claim 18, wherein a width of the main groove section gradually decreases from a center of the main groove section toward an edge of the main groove section.

20. The flexible printed circuit according to any one of claims 1 to 3, wherein the dividing groove penetrates through two side surfaces of the flexible printed circuit in the thickness direction.

21. The flexible printed circuit according to any one of claims 1 to 3, wherein in the thickness direction of the flexible printed circuit, and the moving section bends toward a first direction;
along the first direction, the multilayer section comprises a bottom layer and at least one stacked layer stacked on the bottom layer, and wherein the dividing groove penetrates through each stacked layer, and the bottom layer is connected with the first portion.

22. An electronic device, comprising a housing assembly and the flexible printed circuit according to any one of claims 1 to 21, wherein the flexible printed circuit is located in the housing assembly, and the flexible printed circuit is connected with at least two components in the housing assembly.

23. The electronic device according to claim 22, wherein the housing assembly comprises a first middle frame, a second middle frame, and a rotating shaft, and the first middle frame and the second middle frame are movably connected to two sides of the rotating shaft, respectively;
wherein a first end of the flexible printed circuit is connected with components installed to the first middle frame, and a second end of the flexible printed circuit passes through the rotating shaft and is connected with components installed to the second middle frame.

24. The electronic device according to claim 23, further comprising a first display screen, wherein the first display screen is attached to a first side of the first middle frame and of the second middle frame.

25. The electronic device according to claim 24, further comprising a second display screen, wherein the second display screen is attached to a second side of the second middle frame, and the second side is opposite to the first side; and
wherein the moving section near the second end of the flexible printed circuit is provided with the dividing groove.
